# EUROPÄISCHE PATENTSCHRIFT

(11) **EP 2 732 255 B1**
(45) Veröffentlichungstag und Bekanntmachung des Hinweises auf die Patenterteilung: **22.04.2020**
(21) Anmeldenummer: 12733417.5
(22) Anmeldetag: 27.06.2012
(51) Int. Cl.: G01K 7/18

(54) **MESSWIDERSTAND MIT SCHUTZRAHMEN**
MEASURING RESISTOR HAVING A PROTECTIVE FRAME
RÉSISTANCE DE MESURE MUNIE D'UN CADRE DE PROTECTION

(30) Priorität: 14.07.2011 DE 102011051845
(43) Veröffentlichungstag der Anmeldung: 21.05.2014
(73) Patentinhaber: Heraeus Nexensos GmbH, 63801 Kleinostheim (DE)
(72) Erfinder: WIENAND, Karlheinz, 63741 Aschaffenburg (DE); SANDER, Margit, 63791 Karlstein (DE)
(74) Vertreter: Schultheiss & Sterzel Patentanwälte PartG mbB
(86) Internationale Anmeldenummer: PCT/EP2012/002706
(87) Internationale Veröffentlichungsnummer: WO 2013/007343

(56) Entgegenhaltungen:
- EP-A1- 0 543 413
- DE-A1- 19 757 258
- DE-A1-102007 046 900

## Beschreibung

Die Erfindung betrifft einen Temperatursensor, insbesondere Hochtemperatursensor, umfassend ein Substrat, zumindest zwei Anschlusskontakte und zumindest eine Widerstandsstruktur, wobei die Anschlusskontakte und die zumindest eine der Widerstandsstrukturen auf einer ersten Seite des Substrats angeordnet sind und wobei zumindest eine Widerstandsstruktur durch die Anschlusskontakte elektrisch kontaktiert ist.

Die Erfindung betrifft auch ein Verfahren zur Herstellung eines solchen Temperatursensors, bei dem zumindest eine Widerstandsstruktur auf einer ersten Seite eines Substrats aufgebracht wird und einen Hochtemperatursensor umfassend einen solche Temperatursensor.

Aus der WO 92/15101 A1 ist ein Platinmetall-Temperatursensor mit einer, auf einem Keramiksubstrat aufgebrachten Platin-Widerstandsschicht und einer darüber aufgebrachten Passivierungsschicht bekannt.

Die US 5,202,665 A offenbart ein Verfahren zur Herstellung eines Temperatursensors, wobei eine Platinschicht auf ein Substrat in Dickschichttechnologie aufgebracht wird. Dabei wird Platinpulver mit Oxiden und Bindemitteln gemischt und durch Siebdruck aufgebracht.

Weiterhin ist ein elektrischer Messwiderstand für Widerstandsthermometer sowie ein Verfahren zur Herstellung eines solchen elektrischen Messwiderstandes aus der US 4,050,052 A beziehungsweise der DE 25 27 739 C3 bekannt.

Die JP 57114830 A offenbart einen Temperatursensor, bei dem eine Messelektrode zur Bestimmung der Temperatur auf einem Substrat von einer zweiten Elektrode umgeben ist, um die Luftfeuchtigkeit durch eine Widerstandsmessung der Oberfläche des Substrats zwischen den Elektroden zu bestimmen.

Eine ähnliche Konstruktion schlägt die EP 0 437 325 A2 vor, bei der der Oberflächenwiderstand oder der innere Widerstand des Substrats mit Hilfe von zwei zusätzlichen Elektroden bestimmt wird, die neben einer Widerstandsschicht auf dem Substrat beziehungsweise auf der anderen Seite des Substrats angeordnet sind.

Zur Herstellung eines solchen temperaturabhängigen Widerstands als Temperatursensor wird auf ein Substrat mit einer Oberfläche aus elektrisch isolierendem Werkstoff die Pt-Widerstandsschicht in Mäandern als Dickschicht aufgebracht, wobei die äußere Oberfläche der Widerstandsschicht durch eine Schicht aus elektrisch isolierendem Werkstoff abgedeckt wird, die als Passivierungsschicht dient. Problematisch bei solchen Sensoren ist, dass insbesondere bei hohen Temperaturen metallische Ionen zur Widerstandsschicht wandern und diese beschädigen oder sogar zerstören können. Hierdurch kommt es zu einer Veränderung der Eigenschaften des Temperatursensors.

Aus der EP 0 543 413 A1 ist ein Verfahren zur Herstellung eines temperaturabhängigen, Platin umfassenden Widerstands als Temperatursensor bekannt, wobei im Abstand zu der Widerstandsschicht eine Elektrode aufgebracht wird. Dabei soll eine durch Stromleitung verursachte lonenmigration zur Widerstandsschicht vermieden werden. Die Elektrode ist dazu mit der Widerstandsschicht elektrisch leitend verbunden.

Die EP 0 327 535 B1 offenbart einen Temperatursensor mit einem Dünnschicht-Platinwiderstand als Messelement. Ein Temperaturmesswiderstand aus Platin ist auf einer Oberfläche eines elektrisch isolierenden Substrats angeordnet, wobei das Widerstandselement mit einer dielektrischen Schutzschicht abgedeckt ist, welche vorzugsweise aus Siliziumdioxid besteht und eine Dicke im Bereich von 200 bis 400 nm aufweist. Weiterhin ist als Deckschicht eine Diffusionssperrschicht vorgesehen, die durch Niederschlag von Titan in Sauerstoffatmosphäre zur Bildung von Titanoxid aufgebracht wird. Diese Sperrschicht weist eine Dicke im Bereich von 600 bis 1200 nm auf. Auch wenn die Diffusionssperrschicht den Zutritt von Sauerstoff zur dielektrischen Schicht ermöglicht und damit einen Angriff frei werdender Metall-Ionen aus der Glasschicht auf die Platinschicht teilweise verhindert, kann es bei extremen Umgebungsbedingungen trotzdem zu einem Angriff auf die Platinschicht kommen, so dass ihr physikalisches Verhalten als Temperaturmesselement gestört wird.

Derartige Temperatursensoren können gemäß der EP 0 973 020 A1 mit einer Opferkathode ausgestattet sein und Temperaturen bis zu 1100 °C standhalten. Diese Technik schützt den Messwiderstand gegen chemische oder mechanische Angriffe. Bei diesem Sensor ist jedoch stets zu beachten, dass die Kathode elektrisch richtig angeschlossen ist, denn eine Verwechslung der elektrischen Anschlüsse führt zur Zerstörung des Sensors. Im Übrigen unterliegt der Sensor bei Temperaturen ab 700 °C einer Drift.

Aus der DE 10 2007 046 900 A1 ist ein Temperatursensor mit einer Pt-Widerstandsschicht bekannt, die mit einer Dünnschicht aus Aluminiumoxid abgedeckt ist. Ein Deckel wird auf die, die Widerstandsschicht bedeckende Keramikschicht geklebt. Eine metalldotierte Glaskeramik, die mit einer Anschlussflächen des Temperatursensors elektrisch leitend verbunden ist, bildet eine Opfer-Kathode, um die Widerstandsschicht vor schädlichen Einflüssen von Metallkationen zu schützen und damit den Alterungsprozess des Temperatursensors zu reduzieren oder die Zerstörung des Temperatursensors zu verhindern. Der Einfluss des Stromanschlusses und der Polung des Gehäuses, in dem der Sensor eingebaut wird, kann den Sensor zum Driften bringen.

Nachteilig ist an allen diesen Temperatursensoren, dass die Temperatursensoren einen komplexen Aufbau mit mehreren teils aufwendig konstruierten Schichten aufweisen. Durch den komplexen Aufbau muss die Herstellung in vielen Arbeitsschritten erfolgen, wodurch die Kosten zur Herstellung eines solchen Temperatursensors hoch sind.

Ein weiterer deutlicher Nachteil ist, dass die Polung bei einem Einbau beziehungsweise Einsatz des Temperatursensors beachtet werden muss, da es ansonsten zu einer Verschlechterung bei der Temperaturmessung bis hin zu einer Unbrauchbarkeit des Temperatursensors kommt oder der Temperatursensor sogar gleich beim ersten Betrieb zerstört wird.

Die Aufgabe der Erfindung besteht darin, die Nachteile des Stands der Technik zu überwinden. Insbesondere soll ein einfacher und kostengünstig zu realisierender Aufbau gefunden werden, der auch in der Massenfertigung gut durchzuführen ist.

Eine weitere Aufgabe der vorliegenden Erfindung liegt ferner darin, einen Sensor bereitzustellen, dessen Drift im Anwendungsbereich von 750 °C bis 1200 °C reduziert ist und der bezüglich der Polung des Stromanschlusses und des Gehäuses unempfindlich ist.

Die Aufgabe der Erfindung wird dadurch gelöst, dass an beiden Anschlusskontakten jeweils zumindest eine Elektrode neben der Widerstandsstruktur auf der ersten Seite des Substrats angeordnet ist, die elektrisch mit dem jeweiligen Anschlusskontakt verbunden sind.

Durch diesen Aufbau wird erreicht, dass die Polung des Temperatursensors beim Einbau nicht beachtet werden muss, um die Funktionalität der Elektrode als Opferkathode zu erhalten.

Dabei kann vorgesehen sein, dass die Elektroden einteilig mit der Widerstandsstruktur ausgebildet sind.

Hierdurch ist ein besonders einfacher und kompakter Aufbau des Temperatursensors realisierbar. Der Aufbau kann in einem Arbeitsschritt erfolgen und ist kostengünstig.

Gemäß einer nicht erfindungsgemäßen Ausführung kann vorgesehen sein, dass zumindest an einem Anschlusskontakt zumindest eine Elektrode neben der Widerstandsstruktur auf der ersten Seite des Substrats angeordnet ist, wobei die Elektrode oder die Elektroden einteilig mit der Widerstandsstruktur ausgebildet ist oder sind.

Hierdurch ist ebenfalls ein besonders einfacher und kompakter Aufbau des Temperatursensors realisierbar. Der Aufbau kann in einem Arbeitsschritt erfolgen und ist kostengünstig.

Dabei kann vorgesehen sein, dass der Anschlusskontakt, an den die zumindest eine Elektrode angeschlossen ist, eine Kathode ist.

Dies ist für die Funktionalität der Elektrode als Opferkathode wesentlich.

Bei allen Ausführungsformen kann erfindungsgemäß vorgesehen sein, dass die Elektroden die Widerstandsstruktur zumindest bereichsweise umrahmen, insbesondere zumindest eine Seite von einer Elektrode umrahmt ist, vorzugsweise zumindest zwei Seiten der Widerstandsstruktur von den zumindest zwei Elektroden umrahmt sind, ganz besonders bevorzugt zwei gegenüberliegende Seiten der Widerstandsstruktur.

Durch die Umrahmung der Widerstandsstruktur durch die Elektrode oder die Elektroden ergibt sich ein besonders guter Schutz für die Widerstandsstruktur.

Ferner kann vorgesehen sein, dass das Substrat ein Metalloxid ist, wobei das Metalloxid vorzugsweise beschichtet ist.

Die Metalloxide sind als Substrate besonders geeignet. Insbesondere Al₂O₃ ist als Substrat besonders geeignet.

Eine besonders vorteilhafte Ausgestaltung der Erfindung ergibt sich, wenn vorgesehen ist, dass die Widerstandsstruktur eine mäanderförmige lineare Struktur ist, die vorzugsweise aus einem Metall besteht, besonders bevorzugt aus Platin.

Durch die Mäanderform der Widerstandsschicht kann ein kompakter Aufbau realisiert werden. Platin ist vor allem bei hohen Temperaturen und bei chemisch aggressiven Umgebungen besonders geeignet.

Eine weitere Ausgestaltung der Erfindung sieht vor, dass zumindest die Widerstandsstruktur mit einer dielektrischen Schicht abgedeckt ist, vorzugsweise mit zumindest einer keramischen Schicht, einer Glasschicht oder einer Glaskeramischen Schicht, wobei die dielektrische Schicht vorzugsweise selbstragend ist.

Die Abdeckung führt zu einer deutlichen Verbesserung der Haltbarkeit des Temperatursensors, beziehungsweise daraus aufgebauter Temperatursensor-Chips. Die planen seitlich angeordneten Elektroden sind bei einem solchen Aufbau besonders wirkungsvoll, vor allem dann, wenn die Elektroden die Widerstandschichten zumindest teilweise umrahmen.

Die Aufgabe der Erfindung wird auch gelöst durch ein Verfahren zur Herstellung eines solchen Temperatursensors, bei dem zumindest eine Widerstandsstruktur auf einer ersten Seite eines Substrats aufgebracht wird, wobei eine Beschichtung, vorzugsweise metallische Beschichtung, auf dem Substrat derart aufgebracht wird, dass die Beschichtung die zumindest eine Widerstandsstruktur, zumindest zwei Anschlusskontakte und zumindest eine Elektrode bildet, so dass die Anschlusskontakte die zumindest eine Widerstandsstruktur elektrisch kontaktieren und zumindest eine Elektrode mit zumindest einem Anschlusskontakt elektrisch kontaktieren.

Das Herstellungsverfahren ist besonders einfach und kostengünstig durchzuführen.

Die Aufgabe der Erfindung wird ferner gelöst durch einen Hochtemperatur-Sensorchip umfassend einen solchen Temperatursensor.

Dabei kann vorgesehen sein, dass die Anschlusskontakte des Temperatursensors mit Drähten kontaktiert sind.

Ferner kann vorgesehen sein, dass zumindest die Widerstandsstruktur direkt und vollflächig mit einer keramischen Zwischenschicht und/oder einer Glaskeramik und/oder einer Glasschicht abgedeckt ist.

Diese Schichten dienen dem Schutz vor mechanischen und chemischen Einflüssen auf den Hochtemperatur-Sensorchip.

Vorzugsweise ist ein Deckel auf der keramischen Zwischenschicht angeordnet. Ein elektrischer Temperatursensor mit einer Widerstandsschicht, welche als ein mit elektrischen Anschlüssen versehener Messwiderstand auf einer elektrisch isolierenden Oberfläche eines als Keramik-Substrat ausgebildeten Trägers angeordnet ist, wobei die Widerstandsschicht zum Schutz gegen Kontamination oder Beschädigung von wenigstens einer Schicht aus elektrisch isolierendem Werkstoff abgedeckt ist, die als Passivierungsschicht und/oder als Diffusionsbarriere ausgebildet ist, ist erfindungsgemäß mit einem Deckel geschützt, um Temperaturen über 1000 °C standzuhalten.

Insbesondere wird eine Glaskeramik oder ein keramischer Deckel mit Glaskeramik auf die die Widerstandsschicht bedeckende Keramikschicht geklebt.

Eine die Widerstandsschicht bedeckende Keramikschicht befindet sich auf der der Substratoberfläche abgewandten Seite der Widerstandsschicht.

Vorzugsweise besteht das Substrat aus einem Metalloxid, insbesondere aus Saphir oder einer Keramik.

Zur Bildung einer Diffusionsbarriere beziehungsweise einer Passivierungsschicht kann auch Keramikpulver mittels Dickschichtverfahren auf die Widerstandsschicht aufgebracht und anschließend gesintert werden. Als Vorteil ergibt sich dabei, dass dieses Verfahren sehr kostengünstig ist.

Weiterhin ist es möglich, zur Bildung der Diffusionsbarriere beziehungsweise der Passivierungsschicht Keramikpulver auf die Widerstandsschicht eines gebrannten Substrats im Plasma-Spray-Verfahren aufzubringen. Dies hat den Vorteil, dass die resultierende Schicht aufgrund der hohen Abscheidungstemperaturen auch bei später im Einsatz auftretenden hohen Temperaturen ihre Stabilität beibehält.

Darüber hinaus können die Diffusionsbarriere beziehungsweise die Passivierungsschicht im Dünnschichtverfahren mittels PVD (Physical Vapour Deposition), IAD (Ion Assisted Deposition), IBAD (Ion Beam Assisted Deposition), PIAD (Plasma Ion Assisted Deposition) oder CVD (Chemical Vapour Depostion) oder Magnetron-Sputter-Verfahren aufgebracht werden.

Der Erfindung liegt die überraschende Erkenntnis zugrunde, dass es ausreicht mit einem derartig einfachen Aufbau die negativen Auswirkungen von Metallionen auf die Widerstandschicht deutlich zu reduzieren. Es wurde erstmals gefunden, dass die bei hohen Temperaturen besonders beweglichen Ionen von einer in derselben Ebene wie die Widerstandschicht befindlichen Elektrode als Opferkathode abgefangen werden können. Es reicht also bereits aus, eine einfache Elektrode als Opferkathode vorzusehen, die neben der Widerstandschicht angeordnet ist. Dadurch kann eine besonders einfache Herstellung des Temperatursensors verwendet werden, indem die Widerstandsschicht zusammen mit der als Opferkathode fungierenden Elektrode oder Elektroden und gegebenenfalls auch zusammen mit den Anschlusskontakten als eine Struktur auf einem Substrat aufgebracht wird. Es reicht also erfindungsgemäß ein einziger Arbeitsschritt aus, um die Widerstandsstruktur, alle Elektroden und gegebenenfalls auch die Anschlusskontakte auf dem Substrat zu erzeugen. Dadurch wird die Geschwindigkeit bei der Produktion erhöht und die Herstellungskosten deutlich reduziert. Erfindungsgemäß wird zur Lösung der Aufgabe die Widerstandsstruktur also gegen äußere elektrochemische Einflüsse abgeschirmt.

Eine weitere überraschende Erkenntnis der vorliegenden Erfindung ist es, wenn zwei Elektroden an jeweils unterschiedlichen Anschlusskontakten befestigten werden, so ist es egal, mit welcher Polung die Anschlusskontakte elektrisch angeschlossen werden. Eine der beiden Elektroden wird immer als Kathode geschaltet sein und damit ihre Funktion als Ionen-Getter, das heißt als Opferkathode zum Schutz der Widerstandsschicht erfüllen. Insbesondere bei hohen Temperaturen sind die Ionen derartig beweglich, dass sie in sehr großem Anteil auch dann noch zur Opferkathode wandern, wenn sie dazu um die Widerstandsschicht herum diffundieren müssen. Um einen besseren Schutz der Widerstandsschicht vor Ionen zu erhalten, kann es erfindungsgemäß vorgesehen sein, dass die Elektroden sich um die Widerstandsschicht herum erstrecken. Die Elektroden können sich dabei auch derart weit um die Widerstandsschicht herum erstrecken, dass sie beide die gleichen Seiten der Widerstandsschicht umrahmen. Eine Elektrode ist dann eine innere Elektrode die dichter außen um die Widerstandsschicht herum angeordnet ist und die andere Elektrode ist dann die äußere Elektrode, die dann außen um die innere Elektrode herum angeordnet ist.

Zur Herstellung von Hochtemperatursensoren, bei denen je eine Widerstandsstruktur in einer Ebene auf einem metalloxidischen Substrat aufgebracht wird, werden erfindungsgemäß mit den Widerstandsschichten Anschlusskontakte und von den Anschlusskontakten ausgehende, die Widerstandsstrukturen teilweise einrahmende Elektroden gemeinsam strukturiert.

Erfindungsgemäß können so die Schutzelektroden in einem Verfahrensschritt gemeinsam mit den Widerstandsstrukturen und den Anschlusskontakten erstellt werden. Dies ist für die Massenproduktion besonders günstig.

Erfindungsgemäß wird auch ein Hochtemperatur-Sensorchip mit Anschlusskontakten und einer daran anschließenden, als Widerstand strukturierten Schicht auf einem metalloxidischen Substrat, bevorzugt aus Magnesiumtitanat, Aluminiumoxid, Zirkoniumdioxid-verstärktes Aluminiumoxid (ZTA), Spinell oder ähnlichen Materialien bereitgestellt, bei dem erfindungsgemäß die Widerstandsstruktur Teil einer in einer Ebene angeordneten elektrischen Leiterstruktur ist und in dieser Ebene eine von einem Anschlusskontakt ausgehende Kathode die Widerstandsstruktur zumindest teilweise umrahmt.

Mit der zumindest teilweise umrahmenden Kathode wird die Widerstandsstruktur vor elektrochemischen Beeinträchtigungen geschützt, und weist insbesondere, wenn sie zusätzlich mit einer keramischen Dünn- oder Dickschicht versehen ist, bei höheren Temperaturen einen geringeren Drift in der Temperatur-Widerstands-Charakteristik auf als bisher bekannte Temperatursensoren.

In einer Ausführung mit zwei teilweise einrahmenden Elektroden, die an zwei unterschiedliche Anschlusskontakte elektrisch angeschlossen sind, hat die Polung des Bauteils keine Bedeutung mehr, so dass der Aufwand beim Einbau des Temperatursensors beziehungsweise des den Temperatursensor tragenden Chips und die Gefahr, den Temperatursensor bei einem falschen Einbau zu beschädigen oder zu zerstören, deutlich reduziert ist.

Der Messwiderstand kann vorzugsweise eine Platin aufweisende Widerstandsschicht sein, insbesondere in Dünn- oder Dickschichttechnik ausgeführt. Die Diffusionsbarriere kann in Form einer Zwischenschicht ausgebildet sein. Als vorteilhaft erweist sich dabei, eine kostengünstige Fertigung sowie eine hohe Lebensdauer des temperaturabhängigen Widerstandes.

In einer praxisgerechten Ausführungsform liegt die Dicke der Zwischenschicht im Bereich von 0,2 µm bis 50 µm.

In einer bevorzugten Ausgestaltung gemäß der Erfindung besteht der Träger aus Al₂O₃. Weiterhin besteht auch die Diffusionsbarriere beziehungsweise die Zwischenschicht vorzugsweise aus Al₂O₃, HfO₂ oder einer Mischung aus beiden Materialien, wobei der Gewichtsanteil von Al₂O₃ im Bereich von 20 % bis 70 % liegt.

Weiterhin ist es möglich, die Diffusionsbarriere beziehungsweise Zwischenschicht aus einem Schichtsystem mit einer Schichtfolge von mindestens zwei Schichten aufzubauen, die jeweils aus mindestens einem Oxid aus der Gruppe Al₂O₃, MgO, HfO₂, Ta₂O₅ gebildet sind; dabei kann wenigstens eine Schicht aus zwei der genannten Oxide gebildet sein, wobei vorzugsweise eine physikalische Mischung von Oxiden eingesetzt wird; es ist jedoch auch möglich, Mischoxide zu verwenden.

In einer weiteren Ausgestaltung der Erfindung kann die aus Al₂O₃, MgO, Ta₂O₅ bestehende Gruppe der Oxide um Hafniumoxid erweitert werden.

Vorzugsweise besteht die Diffusionsbarriere beziehungsweise die Passivierungsschicht aus einem Einschichtsystem gemäß Tabelle 1 mit den in den Positionen 1 bis 6 angegebenen Werkstoffen oder aus einem Mehrschichtsystem gemäß Tabelle 2, das wenigstens zwei Schichten 1 und 2 aufweist, wobei sich an Schicht 2 jedoch eine weitere Schicht bzw. mehrere Schichten anschließen können. Die unterschiedlichen Schichtwerkstoffe sind in den einzelnen Positionen beziehungsweise Zeilen mit Ziffern 7 bis 30 bezeichnet.

**Tabelle 1: Einschichtsystem**

| | |
|---|---|
| 1 | nur Al₂O₃ |
| 2 | nur MgO |
| 3 | nur Ta₂O₅ |
| 4 | Mischung Al₂O₃/MgO |
| 5 | Mischung Al₂O₃/Ta₂O₅ |
| 6 | Mischung MgO/Ta₂O₅ |

**Tabelle 2: Mehrschichtsystem**

| | **Schicht 1** | **Schicht 2** |
|---|---|---|
| 7 | nur Al₂O₃ | nur Al₂O₃ |
| 8 | nur Al₂O₃ | nur MgO |
| 9 | nur MgO | nur MgO |
| 10 | nur Ta₂O₅ | nur Ta₂O₅ |
| 11 | nur Ta₂O₅ | nur Al₂O₃ |
| 12 | nur Ta₂O₅ | nur MgO |
| 13 | Mischung Al₂O₃/MgO | nur Al₂O₃ |
| 14 | nur Al₂O₃ | Mischung Al₂O₃/MgO |
| 15 | Mischung Al₂O₃/MgO | Mischung Al₂O₃/MgO |
| 16 | Mischung Ta₂O₅/MgO | nur Al₂O₃ |
| 17 | nur Ta₂O₅ | Mischung Al₂O₃/MgO |
| 18 | Mischung Ta₂O₅/MgO | Mischung Al₂O₃/MgO |
| 19 | Mischung Al₂O₃/Ta₂O₅ | nur Al₂O₃ |
| 20 | nur Al₂O₃ | Mischung Ta₂O₅/MgO |
| 21 | Mischung Al₂O₃/MgO | nur Ta₂O₅ |
| 22 | nur Ta₂O₅ | Mischung Al₂O₃/Ta₂O₅ |
| 23 | nur Al₂O₃ | Mischung Al₂O₃/Ta₂O₅ |
| 24 | Mischung Al₂O₃/MgO | Mischung Ta₂O₅/MgO |
| 25 | Mischung Ta₂O₅/MgO | Mischung Ta₂O₅/MgO |
| 26 | Mischung Al₂O₃/Ta₂O₅ | nur Ta₂O₅ |
| 27 | nur MgO | Mischung Al₂O₃/MgO |
| 28 | nur MgO | Mischung Al₂O₃/Ta₂O₅ |
| 29 | Mischung Al₂O₃/MgO | nur MgO |
| 30 | Mischung Al₂O₃/Ta₂O₅ | nur MgO |

Weiterhin kann die Passivierungsschicht erfindungsgemäß gemäß beiden Ausführungsformen eine Mischung aus SiO₂, BaO und Al₂O₃ aufweisen, wobei der Gewichts-Anteil von SiO₂ im Bereich von 20 % bis 50 % liegt.

Als vorteilhaft erweist sich dabei, dass diese Mischung einen hohen Isolationswiderstand aufweist.

Im Folgenden werden Ausführungsbeispiele der Erfindung anhand von vier schematisch dargestellten Figuren erläutert, ohne jedoch dabei die Erfindung zu beschränken. Dabei zeigt:
- Figur 1:: eine schematische Ansicht einer elektrischen Leiterstruktur mit einer Kathode, die eine Widerstandsstruktur teilweise einrahmt;
- Figur 2:: eine schematische Ansicht einer elektrischen Leiterstruktur mit einer von zwei Elektroden teilweise eingerahmten Widerstandsstruktur;
- Figur 3:: eine schematische Explosionsdarstellung eines erfindungsgemäßen Messwiderstands mit Anschlusskontakten auf einem Substrat; und
- Figur 4:: eine schematische Explosionsdarstellung eines alternativen erfindungsgemäßen Messwiderstands mit Anschlusskontakten auf einem Substrat.

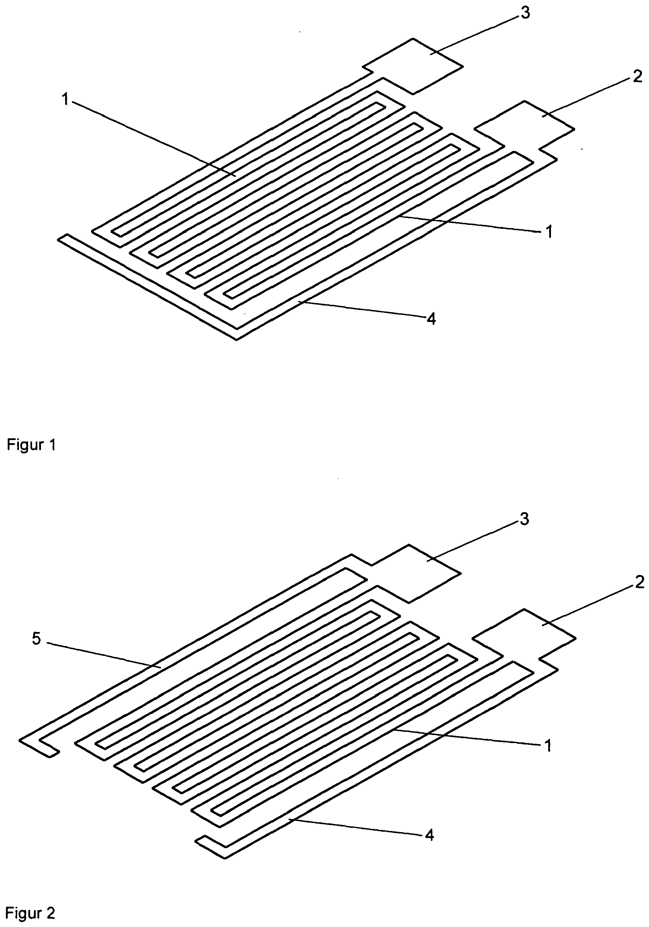

Figur 1 zeigt eine schematische perspektivische Ansicht auf einen Temperatursensor, der so beispielsweise als Dünnschicht auf einem Substrat (nicht gezeigt) aufgetragen sein kann. Der Temperatursensor umfasst eine Widerstandsstruktur 1, die an beiden Enden an zwei Anschlusskontakten 2, 3 angeschlossen ist. Zwischen den Anschlusskontakten 2, 3 erstreckt sich die Widerstandsstruktur 1 in Mäandern als flaches Band. An der Kathode 2 der Anschlusskontakte 2, 3 ist eine Elektrode 4 als Opferelektrode angeschlossen.

Die in Figur 1 gezeigte Elektrode 4 schützt die Widerstandsstruktur 1, insbesondere einen Platinwiderstand vor seitlich eindringenden elektrochemischen Verunreinigungen, die den Widerstandswert der Widerstandsstruktur 1 ändern würden, resultierend in einem störenden Drift oder sogar in einer Zerstörung der Widerstandsstruktur 1. Die elektrochemischen Verunreinigungen, beispielsweise Metallionen, die durch ein Bauteil, beispielsweise ein Hochtemperatur-Sensorchip, umfassend einen solchen Temperatursensor diffundieren, greifen das Metall der Widerstandsstruktur an und lösen die Widerstandsstruktur 1 am Rand auf. Dadurch wird der Querschnitt der Widerstandsstruktur 1 und damit deren elektrischer Widerstand verändert. Die Elektrode 4 bildet durch die negative Aufladung durch die Kathode 2 ebenfalls eine Kathode, so dass positiv geladene Metallionen durch die Elektrode 4 angezogen werden und lediglich die Elektrode 4 angreifen (vergiften) und nicht die Widerstandsstruktur 1.

Die Widerstandsstruktur 1 wird gemeinsam mit den Anschlusskontakten 2, 3 und der Elektrode 4 in einem Verfahrensschritt strukturiert. Dazu wird die gesamte in Figur 1 gezeigte Struktur 1, 2, 3, 4 (der in Figur 1 gezeigte Temperatursensor) mit einem Beschichtungsverfahren auf einem Substrat erzeugt. Der einfache Herstellprozess hierzu ist optimal für die Massenproduktion und geht einher mit minimiertem Materialeinsatz, insbesondere bei Anwendung der wegen der erzielbaren Messgenauigkeit und Miniaturisierung erfindungsgemäß besonders bevorzugten Dünnschichttechnik. Bewährt hat sich diesbezüglich erfindungsgemäß vorzugsweise eine photolithographische Strukturierung einer Platin-Dünnschicht.

Die Elektrode 4 umrahmt die Widerstandstruktur 1 über zwei Seiten. Dabei wird die Seite der Widerstandsstruktur 1, die an der Kathode 2 angeschlossen ist, also während einer Temperaturmessung die stärkste negative Ladung hat, durch die Elektrode 4 besonders gut geschützt. Diffundierende positiv geladene Metallionen werden durch die Elektrode 4 angezogen und dort absorbiert. Diese Anziehung ist, wie überraschend gefunden wurde, insbesondere bei hohen Temperaturen so stark, dass auch die Metallionen, die auf der von der Elektrode 4 nicht eingerahmten Seite der Widerstandsstruktur 1 oder von oben oder von unten existieren, sich zur Elektrode 4 bewegen und von dieser absorbiert werden. Daher reicht schon eine derart einfache Struktur, die mit einer einfachen Dick- oder Dünnschichttechnik als einzelne Schicht aus, um den gewünschten Effekt zu erzielen.

Figur 2 zeigt eine schematische perspektivische Ansicht auf einen alternativen erfindungsgemäßen Temperatursensor. Der Temperatursensor kann in der vorliegenden Form auf einem dielektrischen Substrat (nicht gezeigt) aufgebracht sein. Im Unterschied zu dem in Figur 1 gezeigten Temperatursensor umfasst der nach Figur 2 zwei Elektroden 4, 5, wobei jede an einem der Anschlusskontakte 2, 3 angeschlossen ist.

Von den in Figur 2 gezeigten Elektroden 4, 5 wird eine nach erfolgtem elektrischen Anschluss zur Kathode, die die als Messwiderstand vorgesehene Widerstandsstruktur 1 vor eindringenden elektrochemischen Verunreinigungen schützt. Dies vereinfacht den Verbau des Temperatursensors, da kein falsches Anschließen (Verpolung) mehr möglich ist. Die Drift wird somit unabhängig von den elektrischen Anschlüssen drastisch verringert. Besonders wesentlich ist an dieser Ausführung, dass auch die Polung und das Potential des Gehäuses beliebig sind.

Im Gegensatz zum Stand der Technik ist also bei dieser Ausführung die Polung und das Potential des Gehäuses beliebig. Dies erspart beim Einbau eines die Widerstandsstruktur 1 enthaltenden Chips in das Sensorgehäuse erheblichen Aufwand.

Analog zu Figur 1 und mit den dort beschriebenen Vorteilen wird die Widerstandsstruktur 1 gemeinsam mit den Anschlusskontakten 2, 3 und den Elektroden 4 und 5 in einem Verfahrensschritt strukturiert. Die Elektroden 4 und 5 umrahmen die Widerstandsstruktur 1 auf jeweils einer Seite, wobei die Seiten gegenüberliegend angeordnet sind. Zusätzlich ragen die Elektroden 4, 5 auch noch um eine Ecke auf eine gemeinsame dritte Seite der Widerstandsstruktur 1. Durch wird auch die erste Wendung der mäanderförmigen Widerstandsstruktur 1 von den Elektroden 4, 5 umschlossen und besonders gut geschützt.

Erfindungsgemäß kann auch besonders vorteilhaft vorgesehen sein, wenn sich die Elektroden 4, 5 noch zwischen den Mäandern, vor allem der ersten Mäander erstrecken.

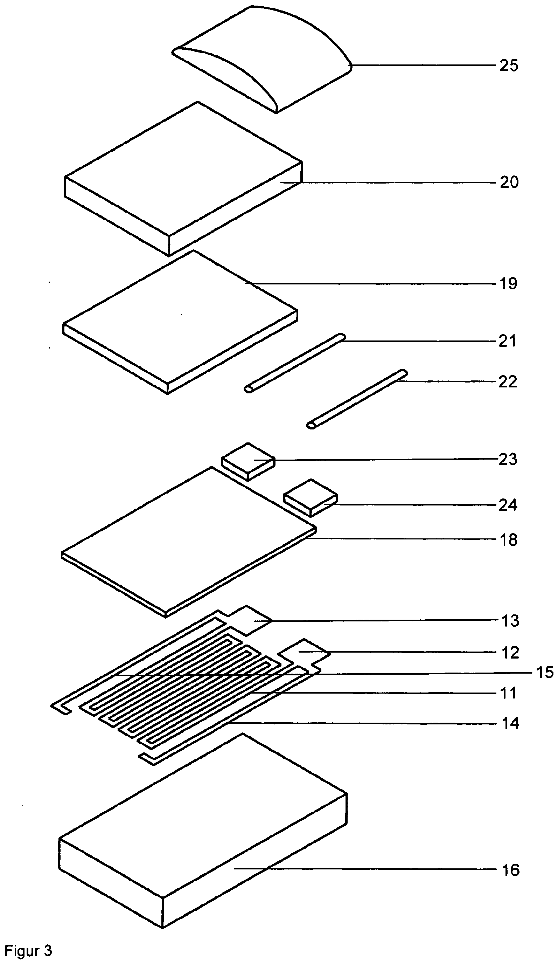

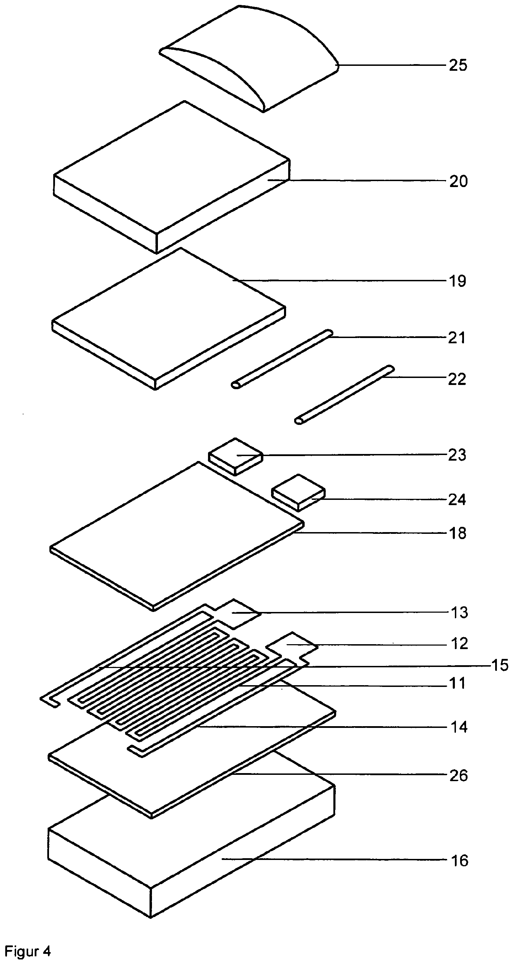

Die Figuren 3 und 4 zeigen eine schematische Explosionsdarstellung eines erfindungsgemäßen Messwiderstands. Eine mäanderförmige Widerstandsstruktur 11 ist mit zwei Anschlusskontakten 12, 13 elektrisch verbunden. Die Widerstandsstruktur 11 wird, analog zu der in Figur 2 gezeigten, auf etwas mehr als zwei Seiten von zwei Elektroden 14, 15 umrahmt. Diese Elektroden 14, 15 sind mit den beiden Anschlusskontakte 12, 13 verbunden und dienen als Opferelektroden zum Schutz der Widerstandsstruktur 11. Die Widerstandstruktur 11, die Anschlusskontakte 12, 13 und die Elektroden 14, 15 sind als einteilige Struktur auf einem Substrat 16 aufgebracht. Die Herstellung der Struktur erfolgt in einem Arbeitsschritt, beispielsweise durch ein photolithographisches Verfahren. Die gesamte Struktur kann also beispielsweise als Dünnschicht auf einer ebenen Oberfläche eines Saphirs oder eines keramischen Substrats 16 angeordnet sein. Die Anschlusskontakte 12, 13 bestehen dabei aus dem gleichen Werkstoff wie die Widerstandsstruktur 11 und die Elektroden 14, 15. Als Werkstoff wird vorzugsweise Platin oder eine Platinlegierung verwendet.

Nach den Figuren 3 und 4 ist die Widerstandsstruktur 11 auf ihrer dem Substrat 16 abgewandten Seite mit einer Diffusionssperrschicht 18 als Zwischenschicht versehen, welche ihrerseits mit einer Passivierungsschicht 19 aus Glas oder Glaskeramik und einem Deckel 20 abgedeckt ist.

Aufgrund des Deckels 20 wird die empfindsame Struktur der Platin enthaltenden Widerstandsstruktur 11 gegen atmosphärische Vergiftungen der Umgebung wirksam geschützt. In einem solchen Mehrschichtenaufbau werden bei hoher Reinheit der Keramik- und Glaskomponenten der Glaskeramik 19 die für die Widerstandsstruktur 11 aus Platin besonders schädlichen Kationen vermieden, welche Platin sehr rasch bei hohen Temperaturen durch Wanderung im elektrischen Feld kontaminieren würden und damit die Temperatur/Widerstands-Funktion der sich daraus ergebenden Platinlegierung drastisch beeinflussen würden, so dass die Hochtemperaturbeständigkeit der Widerstandsstruktur 11 für Temperaturmessungen nicht mehr gegeben wäre. Aufgrund der ersten thermodynamisch stabilen und reinen Hafnium- oder Aluminiumoxidschicht als Zwischenschicht beziehungsweise Diffusionsbarriere 18 wird der Zutritt von Silizium und anderen das Platin vergiftenden Substanzen beziehungsweise Ionen maßgeblich minimiert. Somit ist die beispielsweise mäanderförmig strukturierte Widerstandsstruktur 11 nicht nur von der Substratseite her sondern auch von der diesbezüglich gegenüberliegenden Seite vor Vergiftung geschützt. Die Aufbringung der Zwischenschicht beziehungsweise Diffusionsbarriere 18 kann durch physikalisches Aufdampfen erreicht werden.

Vorzugsweise wird die Aluminiumoxidschicht 18 überstöchiometrisch in einer Weise so aufgebracht, dass eine sehr stabile Schicht von reinem Aluminiumoxid (Al₂O₃) die Platinstruktur der Widerstandsstruktur 11 abdeckt. Die Silizium aufweisende Passivierungsschicht 19 aus Glaskeramik erhält somit nur minimalen Kontakt mit der aktiven Platin-Widerstandsstruktur 11 und eine Abdichtung der Widerstandsstruktur 11 als mechanischer Schutz gegenüber äußeren kontaminierenden Elementen ist damit gewährleistet.

Gemäß Figur 3 wird auf der Glaskeramik 19 ein Keramikplättchen 20 aufgebracht. Das Keramikplättchen 20 stellt eine zusätzliche Passivierung dar und wirkt als mechanischer "Schutzschild" gegen Abrasion durch Teilchen in dem Gehäuse in dem der eigentliche Temperatursensor gefügt ist. Dies schützt vor mechanischem Abrieb und elektrochemischen Verunreinigungen.

In einer Ausführung nach Figur 3 oder 4 sind die Anschlusskontakte 12, 13 mit Anschlussdrähten 21 und 22 über Anschlusspads 23 und 24 mit einem elektrisch isolierenden Fixiertropfen 25 zugentlastet. Diese Fixierung 25 besteht aus hochreinem Glas oder Glaskeramik.

Ergänzend zur eingangs erwähnten Ausführungsform der Zwischensicht als Diffusionsbarriere 18 sei angemerkt, dass diese entweder im Dünnschichtverfahren mit einer Dicke im Bereich von 0,2 bis 10 µm, vorzugsweise 5 µm, oder im Dickschichtverfahren mit einer Dicke im Bereich von 5 bis 50 µm, vorzugsweise 15 µm aufgebracht wird.

Die Dicke der Anschlusskontakt-Pads 23, 24 an der Widerstandsstruktur 11 liegt im Bereich von 10 bis 50 µm, vorzugsweise bei 20 µm. Der Substrat 16 als Träger weist eine Dicke im Bereich von 0,1 mm bis 1 mm, vorzugsweise bei 0,4 mm, besonders bevorzugt 0,38 mm auf.

Die in den Figuren dargestellten Anschlusskontakte 2, 3, 12, 13 sind jeweils auf einer Seite angeordnet; es ist darüber hinaus jedoch auch möglich, Ausführungsformen eines erfindungsgemäßen temperaturabhängigen Widerstands, beziehungsweise Temperatursensors, vorzugsweise Hochtemperatursensors einzusetzen, bei denen beide Anschlusskontakte 2, 3, 12, 13 jeweils auf sich gegenüber liegenden Seiten angeordnet sind.

Wie in Figur 3 zu erkennen ist, erfolgt nach dem Auftragen der Al₂O₃-Dünnschicht 18 das Auftragen der Glaskeramik 19 und dann das Auftragen von Anschlusspads 22, 23 als Dickschichten und anschließend die Keramikabdeckung 20. Danach werden die Anschlussdrähte 21, 22 angeschlossenen und eine Fixierung 25 zur Zugentlastung der Anschlussdrähte 21, 22 aufgebracht.

Gemäß Figur 4 umfasst das Substrat 16 eine Zwischenschicht 26, insbesondere eine Dünnschicht 26 aus Aluminiumoxid oder Hafniumoxid unterhalb der Widerstandsstruktur 11. Auf dieser Zwischenschicht 26 des Substrats 16 befindet sich die als Messwiderstand dienende Widerstandsstruktur 11, beispielsweise als Dünnschicht auf einer ebenen Oberfläche dieser Zwischenschicht 26. Diese Zwischenschicht 26 besteht vorzugsweise aus Aluminiumoxid und schützt die Widerstandsstruktur 11. Die Zwischenschicht 26 ist also eine Beschichtung des Substrats 16, beziehungsweise das Substrat 16 ist mit der Zwischenschicht 26 beschichtet.

### Bezugszeichenliste

- 1, 11: Widerstandsschicht
- 2, 12: Anschlusskontakt / Kathode
- 3, 13: Anschlusskontakt / Anode
- 4, 14: Elektrode
- 5, 15: Elektrode
- 16: Substrat / Metalloxid
- 18: Diffusionssperrschicht / Aluminiumoxidschicht
- 19: Passivierungsschicht / Glaskeramik
- 20: Deckel / Keramik
- 21, 22: Anschlussdraht
- 23, 24: Anschlusspads
- 25: Fixierung / Glastrofpen
- 26: Zwischenschicht / Beschichtung

## Patentansprüche

1. Temperatursensor, insbesondere Hochtemperatursensor, umfassend ein Substrat (16), zumindest zwei Anschlusskontakte (2, 3, 12, 13) und zumindest eine Widerstandsstruktur (1, 11), wobei die Anschlusskontakte (2, 3, 12, 13) und die zumindest eine der Widerstandsstrukturen (1, 11) auf einer ersten Seite des Substrats (16) angeordnet sind und wobei zumindest eine Widerstandsstruktur (1, 11) durch die Anschlusskontakte (2, 3, 12, 13) elektrisch kontaktiert ist, **dadurch gekennzeichnet, dass**
an beiden Anschlusskontakten (2, 3, 12, 13) jeweils zumindest eine Elektrode (4, 5, 14, 15) neben der Widerstandsstruktur (11) auf der ersten Seite des Substrats (16) angeordnet ist, die elektrisch mit dem jeweiligen Anschlusskontakt (2, 3, 12, 13) verbunden sind.

2. Temperatursensor nach Anspruch 1, **dadurch gekennzeichnet, dass**
die Elektroden (4, 5, 14, 15) einteilig mit der Widerstandsstruktur (1, 11) ausgebildet sind.

3. Temperatursensor nach einem der Ansprüche 1 oder 2, **dadurch gekennzeichnet, dass** das Substrat (16) ein Metalloxid ist.

4. Temperatursensor nach Anspruch 3, **dadurch gekennzeichnet, dass**
das Metalloxid beschichtet ist.

5. Temperatursensor nach einem der vorangehenden Ansprüche, **dadurch gekennzeichnet, dass**
die Elektroden (4, 5, 14, 15) die Widerstandsstruktur (1, 11) zumindest bereichsweise umrahmen.

6. Temperatursensor nach einem der vorangehenden Ansprüche, **dadurch gekennzeichnet, dass**
zumindest eine Seite der Widerstandsstruktur (1, 11) von einer der Elektroden (4, 5, 14, 15) umrahmt ist.

7. Temperatursensor nach einem der vorangehenden Ansprüche, **dadurch gekennzeichnet, dass**
zumindest zwei Seiten der Widerstandsstruktur (1, 11) von zumindest zwei Elektroden (4, 5, 14, 15) umrahmt sind, bevorzugt
zwei gegenüberliegende Seiten der Widerstandsstruktur (1, 11) von zumindest zwei Elektroden (4, 5, 14, 15) umrahmt sind.

8. Temperatursensor nach einem der vorangehenden Ansprüche, **dadurch gekennzeichnet, dass**
die Widerstandsstruktur (1, 11) eine mäanderförmige lineare Struktur ist, die vorzugsweise aus einem Metall besteht, besonders bevorzugt aus Platin.

9. Temperatursensor nach einem der vorangehenden Ansprüche, **dadurch gekennzeichnet, dass**
zumindest die Widerstandsstruktur (1, 11) mit zumindest einer dielektrischen Schicht (18, 19, 20) abgedeckt ist, vorzugsweise mit einer keramischen Schicht (18, 19, 20), einer Glasschicht oder einer Glaskeramischen Schicht (19), wobei die dielektrische Schicht (18, 19, 20) vorzugsweise selbstragend ist.

10. Verfahren zur Herstellung eines Temperatursensors nach einem der vorangehenden Ansprüche, bei dem zumindest eine Widerstandsstruktur (1, 11) auf einer ersten Seite eines Substrats (16) aufgebracht wird, **dadurch gekennzeichnet, dass** eine Beschichtung, vorzugsweise metallische Beschichtung, auf der ersten Seite des Substrats (16) derart aufgebracht wird, dass die Beschichtung die zumindest eine Widerstandsstruktur (1, 11), zumindest zwei Anschlusskontakte (2, 3, 12, 13) und zumindest zwei Elektroden (4, 5, 14, 15) bildet, so dass die Anschlusskontakte (2, 3, 12, 13) die zumindest eine Widerstandsstruktur (1, 11) elektrisch kontaktieren und an beiden Anschlusskontakten (2, 3, 12, 13) jeweils zumindest eine Elektrode (4, 5, 14, 15) neben der Widerstandsstruktur (1, 11) elektrisch mit dem jeweiligen Anschlusskontakt (2, 3, 12, 13) verbunden sind.

11. Hochtemperatur-Sensorchip umfassend einen Temperatursensor nach einem der Ansprüche 1 bis 9.

12. Hochtemperatur-Sensorchip nach Anspruch 11, **dadurch gekennzeichnet, dass** die Anschlusskontakte (2, 3, 12, 13) des Temperatursensors mit Drähten (21, 22) kontaktiert sind.

13. Hochtemperatur-Sensorchip nach Anspruch 11 oder 12 **dadurch gekennzeichnet, dass**
zumindest die Widerstandsstruktur (1, 11) direkt und vollflächig mit
- einer keramischen Zwischenschicht (18) und/oder
- einer Glaskeramik (19) und/oder
- einer Glasschicht (20)
abgedeckt ist.

## Claims

1. A temperature sensor, in particular a high temperature sensor, comprising a substrate (16), at least two terminal contacts (2, 3, 12, 13) and at least one resistive structure (1, 11), the terminal contacts (2, 3, 12, 13) and at least one of the resistive structures (1, 11) being disposed on a first side of the substrate (16), and at least one resistive structure (1, 11) being electrically contacted by the terminal contacts (2, 3, 12, 13), **characterized in that**
at least one electrode (4, 5, 14, 15) is disposed on each of the two terminal contacts (2, 3, 12, 13) next to the resistive structure (11) on the first side of the substrate (16), the electrodes being electrically connected to the respective terminal contact (2, 3, 12, 13).

2. The temperature sensor according to claim 1, **characterized in that**
the electrodes (4, 5, 14, 15) are designed in one piece with the resistive structure (1, 11).

3. A temperature sensor according to claims 1 or 2, **characterized in that**
the substrate (16) is a metal oxide.

4. A temperature sensor according to claim 3, **characterized in that** the metal oxide is coated.

5. A temperature sensor according to any one of the preceding claims, **characterized in that**
the electrodes (4, 5, 14, 15) frame the resistive structure (1, 11) at least in some regions.

6. A temperature sensor according to any one of the preceding claims, **characterized in that**
at least one side of the resistive structure (1, 11) is framed by one electrode (4, 5, 14, 15).

7. A temperature sensor according to any one of the preceding claims, **characterized in that**
at least two sides of the resistive structure (1, 11) are framed by at least two electrodes (4, 5, 14, 15), and preferably
two opposing sides of the resistive structure (1, 11) are framed by at least two electrodes (4, 5, 14, 15).

8. A temperature sensor according to any one of the preceding claims, **characterized in that**
the resistive structure (1, 11) is a meander-shaped linear structure, which is preferably made of a metal, particularly preferably platinum.

9. A temperature sensor according to any one of the preceding claims, **characterized in that**
at least the resistive structure (1, 11) is covered with at least one dielectric layer (18, 19, 20), preferably with a ceramic layer (18, 19, 20), a glass layer or a glass ceramic layer (19), the dielectric layer (18, 19, 20) preferably being self-supporting.

10. A method for producing a temperature sensor according to any one of the preceding claims, in which at least one resistive structure (1, 11) is applied to a first side of a substrate (16), **characterized in that**
a coating, preferably a metallic coating, is applied to the first side of the substrate (16) in such a way that the coating forms the at least one resistive structure (1, 11), at least two terminal contacts (2, 3, 12, 13) and at least two electrodes (4, 5, 14, 15), so that the terminal contacts (2, 3, 12, 13) electrically contact the at least one resistive structure (1, 11) and each of the at least two terminal contacts (2, 3, 12, 13) electrically contacts at least one of the at least two electrodes (4, 5, 14, 15) which are positioned besides the resistive structure (1, 11).

11. A high temperature sensor chip, comprising a temperature sensor according to any one of claims 1 to 9.

12. The high temperature sensor chip according to claim 11, **characterized in that** the terminal contacts (2, 3, 12, 13) of the temperature sensor are contacted with wires (21, 22).

13. The high temperature sensor chip according to claim 11 or 12, **characterized in that** at least the resistive structure (1, 11) is covered directly and over the entire surface area with
- a ceramic intermediate layer (18) and/or
- a glass ceramic (19) and/or
- a glass layer (20).

## Revendications

1. Capteur de température, notamment capteur haute température comprenant un substrat (16), au moins deux contacts de connexion (2, 3, 12, 13) et au moins une structure de résistance (1, 11), dans lequel les contacts de connexion (2, 3, 12, 13) et l'au moins une des structures de résistance (1, 11) sont disposés sur un premier côté du substrat (16) et dans lequel au moins une structure de résistance (1, 11) est mise en contact électriquement par les contacts de connexion (2, 3, 12, 13), **caractérisé en ce que**,
chaque fois, au niveau des deux contacts de connexion (2, 3, 12, 13), au moins une électrode (4, 5, 14, 15) est disposée à côté de la structure de résistance (11) sur le premier côté du substrat (16), électrodes qui sont reliés électriquement avec le contact de connexion (2, 3, 12, 13) respectif.

2. Capteur de température selon la revendication 1, **caractérisé en ce que**
les électrodes (4, 5, 14, 15) sont conçues d'un seul tenant avec la structure de résistance (1, 11).

3. Capteur de température selon l'une des revendications 1 ou 2, **caractérisé en ce que** le substrat (16) est un oxyde métallique.

4. Capteur de température selon la revendication 3, **caractérisé en ce que** l'oxyde métallique est revêtu.

5. Capteur de température selon l'une des revendications précédentes, **caractérisé en ce que**
les électrodes (4, 5, 14, 15) entourent au moins par endroits la structure de résistance (1, 11).

6. Capteur de température selon l'une des revendications précédentes, **caractérisé en ce**
**qu'**au moins un côté de la structure de résistance (1, 11) est entouré par une des électrodes (4, 5, 14, 15).

7. Capteur de température selon l'une des revendications précédentes, **caractérisé en ce**
**qu'**au moins deux côtés de la structure de résistance (1, 11) sont entourés par au moins deux électrodes (4, 5, 14, 15), de préférence
deux côtés situés l'un en face de l'autre de la structure de résistance (1, 11) sont entourés par au moins deux électrodes (4, 5, 14, 15).

8. Capteur de température selon l'une des revendications précédentes, **caractérisé en ce que**
la structure de résistance (1, 11) est une structure linéaire en forme de méandres qui est de préférence constituée de métal, de manière particulièrement préférée, de platine.

9. Capteur de température selon l'une des revendications précédentes, **caractérisé en ce**
**qu'**au moins la structure de résistance (1, 11) est recouverte avec au moins une couche diélectrique (18, 19, 20), de préférence avec une couche de céramique (18, 19, 20), une couche de verre ou une couche de céramique de verre (19), où la couche diélectrique (18, 19, 20) est de préférence autoportante.

10. Procédé de fabrication d'un capteur de température selon l'une des revendications précédentes, chez lequel au moins une structure de résistance (1, 11) est rapportée sur un premier côté d'un substrat (16), **caractérisé en ce**
**qu'**un revêtement, de préférence, un revêtement métallique, est rapporté sur le premier côté du substrat (16) de telle manière que le revêtement forme l'au moins une structure de résistance (1, 11), au moins deux contacts de connexion (2, 3, 12, 13) et au moins deux électrodes (4, 5, 14, 15), de sorte que les contacts de connexion (2, 3, 12, 13) sont en contact électriquement avec au moins une structure de résistance (1, 11) et, au niveau des deux contacts de connexion (2, 3, 12, 13), respectivement au moins une électrode (4, 5, 14, 15) est reliée électriquement, à côté de la structure de résistance (1, 11), avec le contact de connexion (2, 3, 12, 13) respectif.

11. Puce de détection haute température comprenant un capteur de température selon l'une des revendications 1 à 9.

12. Puce de détection haute température selon la revendication 11, **caractérisée en ce que**
les contacts de connexion (2, 3, 12, 13) du capteur de température sont mis en contact avec des fils (21, 22).

13. Puce de détection haute température selon la revendication 11 ou la revendication 12, **caractérisée en ce**
**qu'**au moins la structure de résistance (1, 11) est recouverte directement ou sur toute la surface avec
- une couche intermédiaire de céramique (18), et/ou
- une couche de céramique de verre (19, et/ou
- une couche de verre (20).
